Europäisches Patentamt

European Patent Office

Office européen des brevets

(19)

(11) Publication number: **0 091 378**
**B1**

(12) EUROPEAN PATENT SPECIFICATION

(45) Date of publication of patent specification: 29.07.87

(21) Application number: 83400693.4

(22) Date of filing: 05.04.83

(51) Int. Cl.⁴: **H 03 D 7/00**

(54) Frequency conversion unit.

(30) Priority: 06.04.82 JP 56092/82

(43) Date of publication of application:
12.10.83 Bulletin 83/41

(45) Publication of the grant of the patent:
29.07.87 Bulletin 87/31

(84) Designated Contracting States:
DE FR GB IT NL

(56) References cited:
DE-A-2 944 642
DE-B-2 608 939
DE-B-2 611 712
GB-A-1 123 227
GB-A-2 023 954
US-A-3 831 097
US-A-3 870 960
US-A-4 099 126
US-A-4 118 670

Patent Abstracts of Japan vol. 6, no. 136, 23
July 1982 & JP-A-57-061311

(73) Proprietor: FUJITSU LIMITED
1015, Kamikodanaka Nakahara-ku
Kawasaki-shi Kanagawa 211 (JP)

(72) Inventor: Sogo, Hiroyuki
1-15-28, Noge Setagaya-ku
Tokyo 158 (JP)
Inventor: Ohsawa, Zenichi
3016-1-2035, Nagatsuta-cho Midori-ku
Yokohama-shi Kanagawa 227 (JP)
Inventor: Umino, Isamu
2991, Sugao Miyamae-ku
Kawasaki-shi Kanagawa 213 (JP)
Inventor: Nishida, Haruki
Midorihaitsu 12 1613-1, Eda-cho Midori-ku
Yokohama-shi Kanagawa 227 (JP)

(74) Representative: Hasenrader, Hubert et al
Cabinet BEAU DE LOMENIE 55, rue
d'Amsterdam
F-75008 Paris (FR)

## Description

### Background of the invention
#### Field of the invention

The present invention relates to a frequency conversion unit, more particularly to an up converter which contains a mixer which mixes an oscillation output from a local oscillator with an intermediate frequency input and thereby produces a frequency conversion output signal. The frequency conversion unit to which the present invention is concerned is mainly intended to be used in a communications system.

#### Description of the prior art

One of the functions required for a frequency conversion unit is low local leakage. The local oscillation output for the frequency conversion should be used only for achieving the mixing of the frequencies. Therefore, the local oscillation output should not leak into the resultant frequency conversion output signal. That is, it is desirable to reduce the local leakage level to a very low level, zero if possible.

A typical frequency conversion unit, as described hereinafter, has the shortcoming of requiring an additional, special band elimination filter, band pass filter, and isolators for suppressing the local leakage and for absorption of spurious waves and simultaneously an impedance matching, respectively.

To deal with the above shortcoming, U.S.—A—4,249,263 proposed a mixer circuit able to suppress the local leakage without employing such a special band elimination filter, band pass filter, or isolators. This mixer circuit, also described hereinafter, is not so superior in view of the input/output (I/O) impedance characteristics between the local oscillator and a circuit cooperating therewith.

The prior art (U.S.—A—4,099,126), in general, does not mention a cancellation of a local leakage, as does the present application, but discloses a technique for processing both an image generated in a mixer and an image contained in an input signal. Two IF signals are supplied to respective mixers with a phase difference of $\pi/2$ therebetween. To be specific, the invention of the prior art aims at processing the image generated in the mixer (internal image) and the image contained in the input signal (external image), and not at cancelling the leakage output from a local oscillator to the RF output stage of an up converter.

### Summary of the invention

It is an object of the present invention to provide a frequency conversion unit which can suppress local leakage without employing a special band elimination filter, band pass filter, or isolators and which, at the same time, exhibits superior I/O impedance characteristics between the local oscillator and the circuit cooperating therewith.

The above object is attained by a frequency conversion unit in which two mixers are connected in parallel between an input side hybrid circuit and an output side hybrid circuit. In the output side hybrid circuit, of the frequency conversion output signals and the local leakage signals via the two mixers, the local leakage signals are selectively changed to have opposite phases with each other and are then added with each other.

### Brief description of the drawings

The present invention will be more apparent from the ensuing description with reference to the accompanying drawings, wherein:

Fig. 1 is a block diagram of a typical frequency conversion unit;

Fig. 2 is a block diagram representing the principle of the construction according to the present invention;

Fig. 3 shows a mixer circuit of the prior art;

Fig. 4 is a schematic circuit diagram of a hybrid circuit and its neighboring members in Fig. 2;

Fig. 5 is a block diagram representing another principle of the construction according to the present invention;

Fig. 6 is a plan view of a first example of an actual circuit pattern for fabrication of the frequency conversion unit shown in Fig. 2; and

Fig. 7 is a plan view of a second example of an actual circuit pattern for fabrication of the frequency conversion unit shown in Fig. 2.

### Description of the preferred embodiments

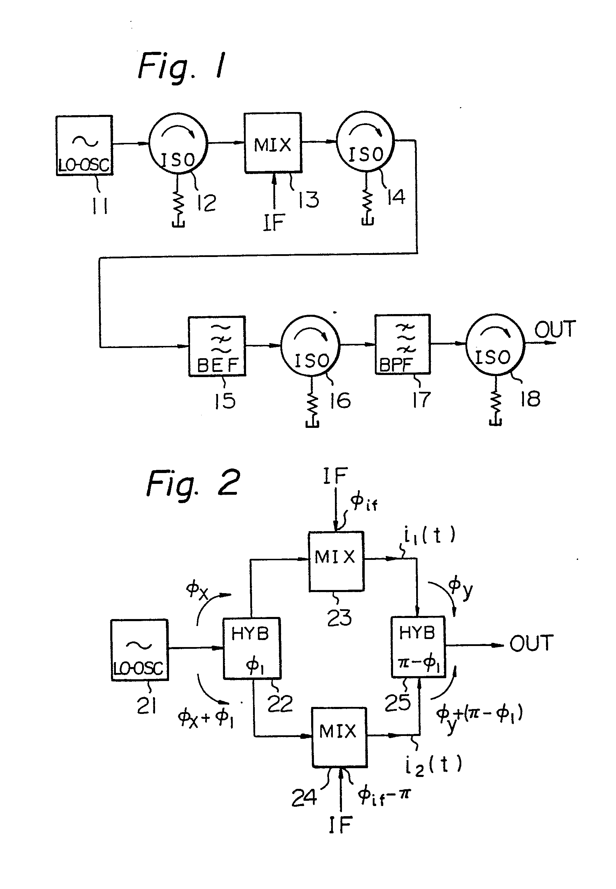

Figure 1 is a block diagram of a typical frequency conversion unit. In Fig. 1, a mixer (MIX) 13 is provided with a first input and a second input. The first input receives, via an isolator 12, a local oscillation output from a local oscillator (LO—OSC) 11. The second input receives an intermediate frequency signal IF which is mixed with the local oscillation output. The mixer 13 is a so-called single-balance type including two diodes therein. Thus, the mixer 13 produces a frequency conversion output signal having a frequencies of $(f_{LO} \pm f_{iF})$ and, at the same time, a local leakage signal having a frequency of $f_{LO}$, where $f_{LO}$ denotes a local oscillation frequency and $f_{iF}$ denotes an intermediate frequency. Of these frequencies, only the desired frequency, i.e., $(f_{LO} + f_{iF})$ or $(f_{LO} - f_{iF})$, is extracted through a band pass filter (BPF) 17. This results in a frequency conversion output signal OUT. A band elimination filter (BEF) 15 functions to eliminate the local leakage signal. Isolators (ISO) 12, 14, 16, and 18 are inserted in the circuit for absorbing spurious waves and also for impedance matching.

As mentioned above, this type of frequency conversion unit has shortcomings in that the band elimination filter 15 and band pass filter 17 are needed for suppressing the local leakage signal. Also, the local leakage suppression is not perfect.

Figure 2 is a block diagram representing the principle of the construction according to the present invention. In this figure, the meanings of the characters IF and OUT are the same as mentioned with reference to Fig. 1. Also, a local oscillator (LO—OSC) 21 and mixers (MIX) 23 and 24 are identical to those having the same characters shown in Fig. 1. The difference between the frequency conversion units of Figs. 1 and 2 is that a first hybrid circuit (HYB) 22 of a second hybrid circuit (HYB) 25 are introduced in the construction of Fig. 2. Also, two parallel-connected mixers are introduced therein.

Why and how the local leakage signal can be suppressed by the construction of Fig. 2 will be proved later using mathematical expressions, however, in brief, the principle of construction is that the local leakage signal travels through the first mixer 23 and the local leakage signal traveling through the second mixer 24 are placed $\pi$ (radian) out of phase with each other and then combined at the second hybrid 25 so that only the local leakage signals are cancelled.

Incidentally, the first hybrid circuit 22 achieves a power branching operation with the phase difference of $\phi_1$ (refer to $\phi_1$ in Fig. 2), while the second hybrid circuit 25 achieves a power combining operation with the phase difference of $(\pi-\phi_1)$ (refer to $(\pi-\phi_1)$ in Fig. 2). Each of the hybrid circuits 22 and 25 is a 3 dB hybrid circuit.

Now, assume that a voltage $V_{LO}$ of a local oscillation output signal from the local oscillator 21 is expressed by the following expression (1):

$$V_{LO}=v_{LO} \sin(\omega_{LO}t+\phi_{LO}) \tag{1}$$

where, the symbol $\phi_{LO}$ is an arbitrary phase for general expression of $V_{LO}$ and $\omega_{LO}$ stands for $2\pi f_{LO}$.

A voltage $V_{LO(23)}$ of the local oscillation output signal to be inputted to the mixer 23 is expressed by the following expression (2), where the arbitrary phase is set to be zero for simplification:

$$V_{LO(23)}=\frac{1}{\sqrt{2}}v_{LO} \sin\omega_{LO}t \tag{2}$$

On the other hand, a voltage $V_{LO(24)}$ of the local oscillation output signal to be inputted to the mixer 24 is expressed by the following expression (3):

$$V_{LO(24)}=\frac{1}{\sqrt{2}}v_{LO} \sin(\omega_{LO}t-\phi_1) \tag{3}$$

where, $\phi_1$ is selected from the range of $+\pi \geqq \phi_1 \geqq 0$ and $v_{LO}$ denotes a peak amplitude of $V_{LO(24)}$.

Next, assume that the local leakage signal having a voltage $V_{LL(23)}$ is contained in the output signal from the mixer 23, where the voltage $V_{LL(23)}$ is expressed as follows:

$$V_{LL(23)}=v_{LL} \sin\omega_{LO}t \tag{4}$$

where, $v_{LL}$ denotes the effective voltage value of $V_{LL(23)}$. In this case, a voltage of the output signal from the mixer 24 is expressed as follows:

$$V_{LL(24)}=v_{LL} \sin(\omega_{LO}t-\phi_1) \tag{5}$$

When these local leakage signals pass through the hybrid circuit 25, since the local leakage signal through the mixer 24 is $(\pi-\phi_1)$ out of phase with respect to the local leakage signal from the mixer 23, the above recited $V_{LL(24)}$ of expression (5) is modified to be as follows:

$$V_{LL(24)}=v_{LL} \sin\{\omega_{LO}t-\phi_1-(\pi-\phi_1)\}$$

$$=v_{LL} \sin(\omega_{LO}t-\pi) \tag{6}$$

The $V_{LL(24)}$ of the expression (6) is clearly $\pi$ out of phase with respect to the $V_{LL(23)}$ of the expression (4).

Therefore, the local leakage can theoretically be suppressed to zero if the local leakage levels from the two mixers 23 and 24 are the same. This is the first feature of the construction shown in Fig. 2. It should be understood, however, that a feature identical to this first feature is also produced from the prior art mixer circuit in U.S. Patent No. 4,249,263.

Regarding the phase $\phi_1$, according to the first feature mentioned above, the local leakage can be suppressed to zero at any value of the phase $\phi_1$ in the range from $|\phi_1|=0$ to $|\phi_1|=\pi$. There is a second feature regarding the above phase $\phi_1$. That is, when $\phi_1$ is selected to be

$$\phi_1=+\frac{\pi}{2},$$

a reflection wave from the mixer 23 and a reflection wave from the mixer 24 are $\pi$ out of phase with each other. Therefore, these reflection waves are cancelled. This leads to an improvement in the I/O impedance characteristics of the hybrid circuit 25.

Such an improvement is effected in the unit of Fig. 1 by the isolator 12. It should be noted, however, that, in Fig. 2, if the hybrid 22 has inferior I/O impedance characteristics with respect to the local oscillator 21, the above-mentioned reflection waves affect the local oscillator 21, with a result that the local oscillator 21 necessarily, carries an unstable load. Thus, the oscillator 21 cannot maintain a stable oscillation frequency of the output therefrom. On the other hand, the prior art mixer circuit has inferior I/O impedance characteristics.

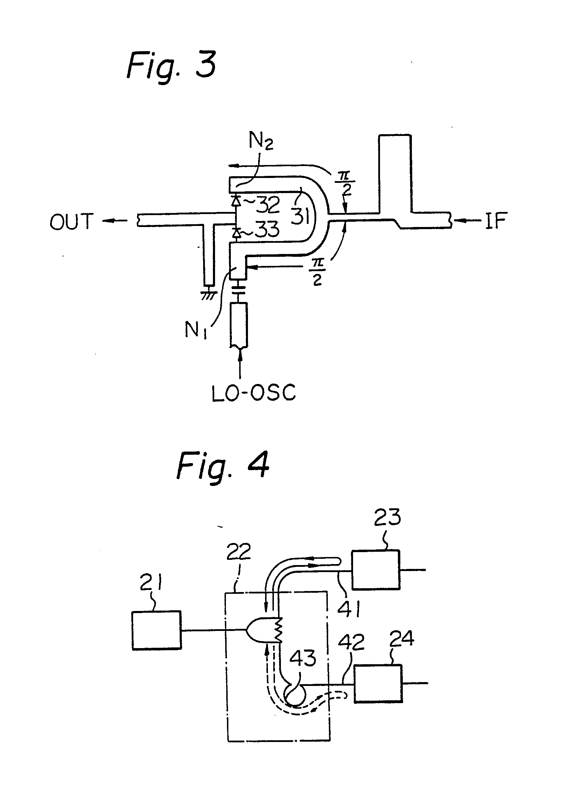

Figure 3 shows a mixer circuit of the prior art. This corresponds to Fig. 2 of U.S. Patent No. 4,249,263. In this figure, the parts denoted by characters OUT, IF, and LO—OSC are substantially the same as those of Figs. 1 and 2. The mixer circuit of Fig. 3 can suppress the aforesaid local leakage. This is because, a node $N_1$ and a node $N_2$ are linked with a $\frac{1}{2}$ wavelength line 31. Series-connected diodes 32 and 33 are sandwiched between these nodes $N_1$ and $N_2$. This means the local oscillation signal appearing at the node $N_2$ is $\pi$ radian out of phase with respect to the local oscillation signal. Accordingly, the local oscillation signals at the nodes $N_1$ and $N_2$ are cancelled, and thus the local leakage signal cannot appear in the frequency conversion output signal OUT.

However, as mentioned above, the mixer circuit of Fig. 3 has inferior I/O impedance characteristics between the local oscillator (LO—OSC) and the circuit cooperating therewith. To be specific, the reflection wave from the cooperating circuit influences the local oscillation. To be more specific, the reflection wave, traveling from the node $N_1$, via the line 31, to the node $N_2$ and returning at the node $N_2$ and reaching, via the line 31, the node $N_1$, has a

$$2\pi\left(\frac{\pi}{2}+\frac{\pi}{2}+\frac{\pi}{2}+\frac{\pi}{2}\right)$$

radian phase difference with respect to the wave supplied at the node $N_1$. Consequently, this wave is in phase with the above-mentioned reflection wave, and, thereby, the local oscillator (LO—OSC) suffers from the reflection wave. As a result, the local oscillator cannot maintain stable oscillation.

Contrary to the above, in the present invention, the hybrid circuit 22 exhibits good I/O impedance characteristics when the phase $\phi_1$ of Fig. 2 is selected to be

$$+\frac{\pi}{2}$$

Figure 4 is a schematic circuit diagram of the hybrid circuit 22 and its neighboring members in Fig. 2. Members identical to those of Fig. 2 are referenced by the same numerals. In Fig. 4, the reflection wave traveling along a line 41 is indicated by a solid line arrow, while the reflection wave traveling along a line 42 is indicated by a broken line arrow. In this case, the reflection wave along the line 41 is

$$\pi\left(\frac{\pi}{2}+\frac{\pi}{2}\right)$$

radian out of phase with respect to the reflection wave along the line 42. This is because the line 42 is provided with a $\frac{1}{4}$ wavelength line 43 which creates a phase difference of

$$\phi_1\left(=+\frac{\pi}{2}\right).$$

As a result, these reflection waves are cancelled and there is no influence on the local oscillator 21, which relates to the aforementioned second feature of the present invention.

Returning again to Fig. 2 and the last expression (6), explanations will be made on the fact that although the local leakage is sufficiently suppressed, the desired frequency conversion output signal OUT is not suppressed selectively and can pass, as it is, through the hybrid circuit 25. A differential conductance g(t) of each diode can be expressed by expression (7), which diodes are contained in each mixer (23, 24) and are energized by the local oscillation output signal:

$$g(t) = g_0 + \sum_{n=1}^{\infty} g_n \sin n \cdot (\omega_{LO}t + \phi_{LO}) \qquad (7)$$

where, the symbol $g_n$ denotes the differential conductance of the diode for the n-th order harmonic wave, t denotes time, and $g_0$ is average conductance. Further, the voltage $e_{if}(t)$ of the intermediate frequency signal IF can be expressed by expression (8):

$$e_{if}(t) = E_{if} \cos(\omega_{if}t + \phi_{if}) \qquad (8)$$

where, the symbol $E_{if}$ denotes an effective voltage value of $e_{if}$. The term $\omega_{if}$ equals $2\pi f_{IF}$. The aforesaid arbitrary phase $\phi_{LO}$ at each of the mixers 23 and 24 is set as $\phi_{if}$. The phase $\phi_{LO}$ at the first and second hybrid circuits 22 and 25 are set as $\phi_x$ and $\phi_y$, respectively. Assuming that g(t) and $e_{if}$ are determined as in expressions (7) and (8), respectively, a signal current i(t) obtained at the output of the mixer is determined by the following set of expressions (9):

$$i(t) = g(t) \cdot e_{if}(t)$$

$$= g_0 E_{if} \cos(\omega_{if}t + \phi_{if})$$

$$+ \sum_{n=1}^{\infty} \frac{g_n}{2} E_{if} [\sin\{(n\omega_{LO}+\omega_{if})t+(n\phi_{LO}+\phi_{if})\}$$

$$+ \sin\{(n\omega_{LO}-\omega_{if})t+(n\phi_{LO}-\phi_{if})\}] \qquad (9)$$

In the above expressions (9), when the current i'(t), defined only by the first order harmonic wave component (n=1), is extracted selectively from the expressions, the current i'(t) can be expressed as follows:

$$i'(t) = \frac{g_1}{2} E_{if}[\sin\{(\omega_{LO}+\omega_{if})t+(\phi_{LO}+\phi_{if})\}$$

$$+ \sin\{(\omega_{LO}-\omega_{if})t+(\phi_{LO}-\phi_{if})\}] \qquad (10)$$

In the above expression (10), the first bracketed term represents a function relating to the upper frequencies of the first order harmonic wave, and the second bracketed term represents a function relating to the lower frequencies thereof.

Referring again to Fig. 2, a current $i_1(t)$ of a signal converted in the mixer 23 can be expressed as follows, where the phase component $\phi_{LO}$ of the local oscillator (LO—OSC) is set as zero.

$$i_1(t) = \frac{g_1}{2} E_{if}[\sin\{(\omega_{LO}-\omega_{if})t-\phi_x+\phi_{if}\}$$

$$+ \sin\{(\omega_{LO}-\omega_{if})t-\phi_x-\phi_{if}\}] \qquad (11)$$

On the other hand, a current $i_2(t)$ of a signal converted in the mixer 24 can be expressed as follows:

$$i_2(t) = \frac{g_1}{2} E_{if}[\sin\{(\omega_{LO}+\omega_{if})t-(\phi_x+\phi_1)$$

$$+ (\phi_{if}-\pi)\} + \sin\{(\omega_{LO}-\omega_{if})t$$

$$- (\phi_x+\phi_1)-(\phi_{if}-\pi)\}]$$

$$= \frac{g_1}{2} E_{if}[\sin\{(\omega_{LO}+\omega_{if})t-\phi_x-\phi_1+\phi_{if}-\pi\}$$

$$+ \sin\{(\omega_{LO}-\omega_{if})t-\phi_x-\phi_1-\phi_{if}+\pi\}] \qquad (12)$$

5

The aforesaid current $i_1(t)$ is transformed, when passed through the second hybrid circuit 25, into a current $i'_1(t)$ to be as follows:

$$i'_1(t)=\frac{g_1}{2}E_{lf}[\sin\{(\omega_{LO}+\omega_{lf})t-\phi_x-\phi_y+\phi_{lf}\}$$

$$+\sin\{(\omega_{LO}-\omega_{lf})t-\phi_x-\phi_y-\phi_{lf}\}] \tag{13}$$

Also, the aforesaid current $i_2(t)$ is transformed, when passed through the second hybrid circuit 25, into a current $i'_2(t)$ to be as follows:

$$i'_2(t)=\frac{g_1}{2}E_{lf}[\sin\{(\omega_{LO}+\omega_{lf})t-\phi_x-\phi_1$$

$$+\phi_{lf}-\pi-\phi_y-(\pi-\phi_1)\}$$

$$+\sin\{(\omega_{LO}-\omega_{lf})t-\phi_x-\phi_1-\phi_{lf}+\pi$$

$$-\phi_y-(\pi-\phi_1)\}]$$

$$=\frac{g_1}{2}E_{lf}[\sin\{(\omega_{LO}+\omega_{lf})t-\phi_x-\phi_y+\phi_{lf}$$

$$-2\pi\}+\sin\{(\omega_{LO}-\omega_{lf})t-\phi_x-\phi_y-\phi_{lf}\}] \tag{14}$$

In the last term of expression (14), since the phase 2 is in phase with the phase 0, the current $i'_2(t)$ can be rewritten as follows:

$$i'_2(t)=\frac{g_1}{2}E_{lf}[\sin\{(\omega_{LO}+\omega_{lf})t-\phi_x-\phi_y+\phi_{lf}\}$$

$$+\sin\{(\omega_{LO}-\omega_{lf})t-\phi_x-\phi_y-\phi_{lf}\}] \tag{15}$$

The current $i'_1(t)$ of expression (13) and the current $i'_2(t)$ of expression (15) are analyzed as follows. Regarding the current $i'_1(t)$ of expression (13), a current $i_{1u}(t)$ corresponding to an upper frequency component $(f_{LO}+f_{iF})$ of the first order harmonic wave signal passed through the mixer 23 is derived from expression (13) to be as follows:

$$i_{1u}(t)=\frac{g_1}{2}E_{lf}\ \sin\{(\omega_{LO}+\omega_{lf})t-\phi_x-\phi_y+\phi_{lf}\} \tag{16}$$

Also regarding the current $i'_1(t)$ of expression (13), a current $i_{1l}(t)$ corresponding to a lower frequency component $(f_{LO}-f_{iF})$ of the first order harmonic wave signal passed through the mixer 23, on the other hand, is derived from expression (13) to be as follows:

$$i_{1l}(t)=\frac{g_1}{2}E_{lf}\ \sin\{(\omega_{LO}-\omega_{lf})t-\phi_x-\phi_y-\phi_{lf}\} \tag{17}$$

Similarly, an upper frequency component current $i_{2u}(t)$ of the first order harmonic wave signal passed through the mixer 24 and a lower frequency component current $i_{2l}(t)$ thereof are expressed by the following expressions (18) and (19), respectively:

$$i_{2u}(t)=\frac{g_1}{2}E_{lf}\ \sin\{(\omega_{LO}+\omega_{lf})t-\phi_x-\phi_y+\phi_{lf}\} \tag{18}$$

$$i_{2l}(t)=\frac{g_1}{2}E_{lf}\ \sin\{(\omega_{LO}-\omega_{lf})t-\phi_x-\phi_y-\phi_{lf}\} \tag{19}$$

In the above-recited expressions (16) and (18), a look at the terms relating to the phases shows the phases to be in-phase, i.e., the same phase of $(\phi_x+\phi_y+\phi_{if})$. Therefore, a current $i_u(t)$ of the following expression (20) is obtained when the currents $i_{1u}(t)$ and $i_{2u}(t)$ are combined with each other by the second hybrid circuit 25:

$$i_u(t)=g_1\ E_{if}\ \sin\{(\omega_{LO}+\omega_{if})t-\phi_x-\phi_y+\phi_{if}\} \qquad (20)$$

Similarly, regarding the lower frequency component, a current $i_l(t)$ can be derived from the above expressions (17) and (19) to be as follows:

$$i_l(t)=g_1\ E_{if}\ \sin\{(\omega_{LO}-\omega_{if})t-\phi_x-\phi_y-\phi_{if}\} \qquad (21)$$

Thus, the mixed wave signals from the mixers remain as they are and are not suppressed. This is because the mixed wave signals from the mixers 23 and 24 are combined in phase with each other at the circuit 25.

All of the circuit elements for the principle of the construction shown in Fig. 2 can easily be realized. Further, the intermediate frequency signals IF for the mixers 23 and 24 are produced by means of a 3 dB—180° hybrid circuit.

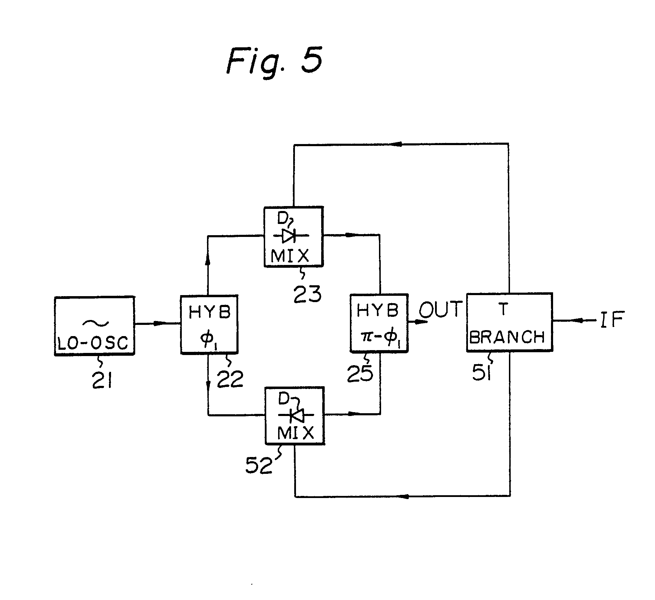

Figure 5 is a block diagram representing another principle of the construction according to the present invention. Differences between the constructions of Fig. 5 and Fig. 2 are, first, the aforesaid 3 dB—180° hybrid circuit is replaced by an ordinary T-branch circuit 51; and, second, the diodes D for comprising the mixers 23 and 52 are mounted therein in inverse polarity with each other. Therefore, in this construction of Fig. 5, the intermediate frequency signal IF for the mixer 23 can also be 180° out of phase with respect to the signal IF for the mixer 52.

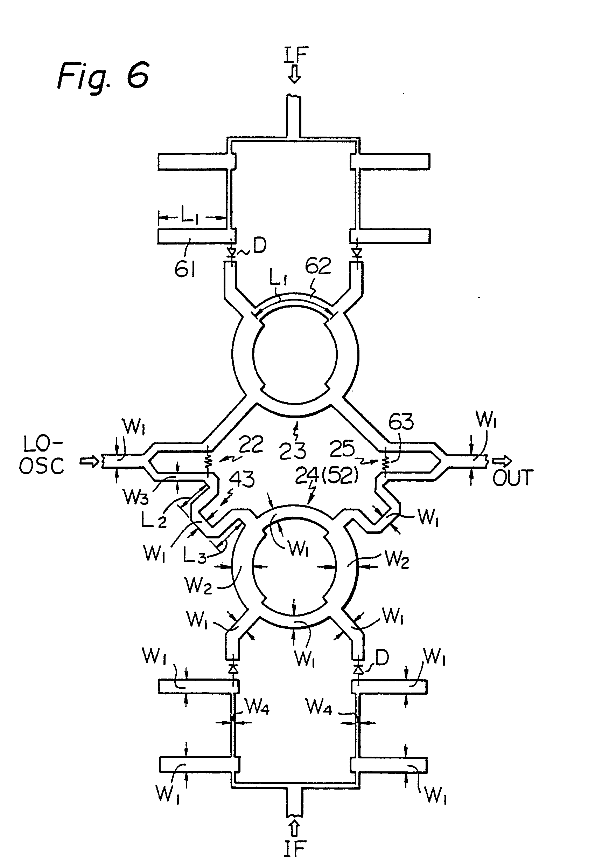

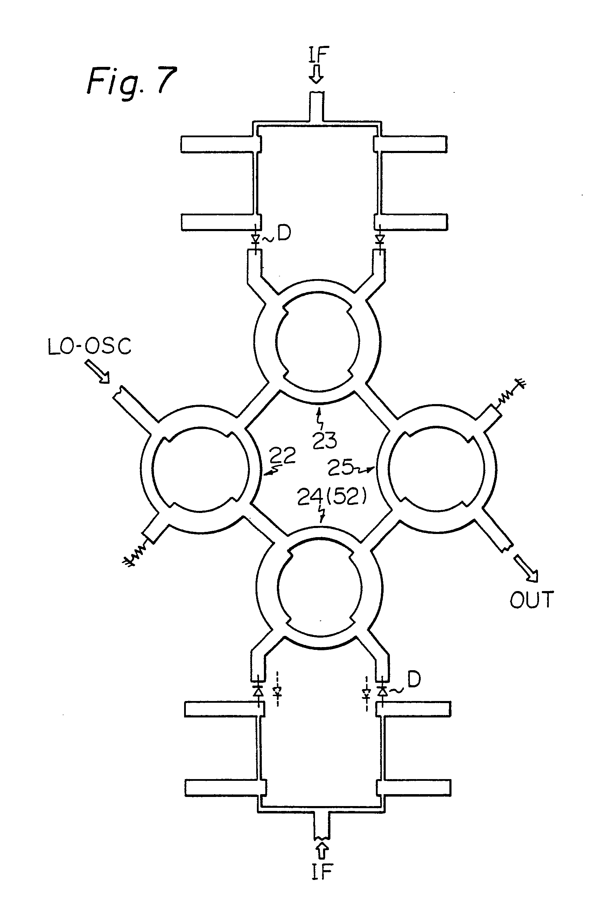

Figure 6 is a plan view of a first example of an actual circuit pattern for fabrication of the frequency conversion unit shown in Fig. 2. Figure 7 is a plan view of second example of an actual circuit pattern for fabrication of the frequency conversion unit shown in Fig. 2. In Figs 6 and 7, members corresponding to those of Figs. 2 and 4 are indicated by the same reference numerals, symbols and characters.

In Fig. 6, the length of a line 61 is preferably the same as that of a line 62, i.e., $L_1$. The length $L_1$ is determined as the sum of lengths $L_2$ and $L_3$ of the line 43. When the width $W_1$ is normalized as 1, then the width $W_2$ becomes 2, the width $W_3$ becomes 0.5, and the width $W_4$ becomes 0.2. The resistance value of a resistor 63 is predetermined to match a characteristic impedance of a cooperating transmission line. The portion 24 (mixer 24 in Fig. 2) is the same as the portion 52 (mixer 52 in Fig. 5), except that the diodes D in the mixer 52 are arranged inversely in polarity with respect to the diodes D of the mixer 24, as are the diodes indicated by broken lines. This also applies to diodes D shown in Fig. 7.

As explained above in detail, according to the frequency conversion unit of the present invention, local leakage can theoretically be suppressed completely. Therefore, the special band elimination filter and the band pass filter can be omitted. Further, the local oscillator can produce a stable oscillation frequency signal. Furthermore, the backoff characteristic can be improved, because each of the two mixers receives 3 dB reduced local oscillation signals via the first hybrid circuit. Therefore, each mixer can operate with a larger dynamic range, compared with a single mixer which receives a full level of the local oscillation signal.

**Claims**

1. A frequency conversion unit used for an up converter, including a local oscillator and at least one mixer means, said at least one mixer means receiving, at its first input, the output from said local oscillator and, at its second input, an intermediate frequency signal, thereby producing a frequency conversion output signal therefrom, said at least one mixer means being comprised of a first mixer and a second mixer connected in parallel, and

a first hybrid circuit and a second hybrid circuit characterized in that said first hybrid circuit is operative to produce two outputs having a phase difference of a predetermined value $\phi_1$ therebetween by branching an oscillation output from said local oscillator, said second hybrid circuit is operative to make a phase difference of a predetermined value $(\pi-\phi_1)$ between the outputs from the first and second mixers and combines those outputs therein so that said frequency conversion output signal is produced therefrom; and

in that said intermediate frequency signal in the first mixer is $\pi$ radian out of phase with respect to the intermediate frequency signal in the second mixer, and said value $\phi_1$ is preset as

$$\phi_1=+\frac{\pi}{2}$$

as an optimum value.

2. A frequency conversion unit as set forth in claim 1, wherein each of said first and second mixers is

**0 091 378**

fabricated as a diode mixer, two diodes in the first mixer are arranged inversely in polarity with respect to the two diodes in the second mixer, and, thereby, the intermediate frequency signal in the first mixer is necessarily π radian out of phase with respect to that in the second mixer.

3. A frequency conversion unit as set forth in claim 1, wherein each of said first and second hybrid circuits is fabricated as a 3 dB hybrid circuit.

4. A frequency conversion unit as set forth in claim 1, wherein said value $\phi_1$ is selected from a range $+\pi \geqq \phi_1 \geqq 0$.

5. A frequency conversion unit as set forth in claim 2, wherein said intermediate frequency signals for the first and second mixers are commonly supplied by way of a T-branch circuit from a single intermediate frequency signal source.

## Patentansprüche

1. Frequenzwandlereinheit, zur Verwendung als Aufwärtsumsetzer, mit einem örtlichen Oszillator und wenigstens einer Mischeinrichtung, welche an ihrem ersten Eingang den Ausgang des genannten lokalen Oszillators und an ihrem zweiten Eingang ein Zwischenfrequenzsignal empfängt, wodurch sie ein frequenzgewandeltes Ausgangssignal erzeugt, wobei die wenigstens eine Mischeinrichtung aus einem ersten und einem zweiten Mischer besteht, die parallel verbunden sind, und mit einer ersten Hybridschaltung und einer zweiten Hybridschaltung, dadurch gekennzeichnet, daß die genannte erste Hybridschaltung betriebbar ist, um zwei Ausgänge zu erzeugen, die zwischeneinander eine Phasendifferenz von einem vorbestimmten Wert $\phi_1$ haben, durch Verzweigen eines Oszillationsausganges von dem genannten lokalen Oszillator, die genannte zweite Hybridschaltung betreibbar ist, um eine Phasendifferenz von einem vorbestimmten Wert $(\pi - \phi_1)$ zwischen den Ausgängen von dem ersten und dem zweiten Mischer herzustellen, und jene Ausgänge darin so kombiniert, daß das genannte frequenzgewandelte Ausgangssignal daraus erzeugt wird;

und daß das genannte Zwischenfrequenzsignal in dem ersten Mischer in Bezug auf das Zwischenfrequenzsignal in dem zweiten Mischer um π Radian außer Phase ist, und der genannte Wert $\phi_1$ auf

$$\phi_1 = + \frac{\pi}{2}$$

als einem optimalen Wert voreingestellt ist.

2. Frequenzwandlereinheit nach Anspruch 1, bei welcher jeder der ersten und zweiten Mischer als ein Dioden mischer hergestellt ist, zwei Dioden in dem ersten Mischer mit inverser Polarität in Bezug auf die beiden Dioden des zweiten Mischers angeordnet sind und, dadurch, das Zwischenfrequenzsignal in dem ersten Mischer in Bezug auf dasjenige des zweiten Mischers notwendigerweise um π Radian außer Phase ist.

3. Frequenzwandlereinheit nach Anspruch 1, bei der jede der genannten ersten und zweiten Hybridschaltungen als eine 3 dB-Hybridschaltung ausgebildet ist.

4. Frequenzwandlereinheit nach Anspruch 1, bei der der genannte Wert $\phi_1$ aus einem Bereich $+\pi \geqq \phi_1 \geqq 0$ ausgewählt ist.

5. Frequenzwandlereinheit nach Anspruch 2, bei der die Zwischenfrequenzsignale für die ersten und zweiten Mischer gemeinsam über eine T-Verzweigungsschaltung von einer einzigen Zwischenfrequenzsignalquelle zugeführt werden.

## Revendications

1. Unité de conversion de fréquence utilisée comme convertisseur additif, comportant un oscillateur local et au moins un moyen mélangeur, ce moyen mélangeur recevant, à une première entrée, le signal de sortie dudit oscillateur local et, à une deuxième entrée, un signal de fréquence intermédiaire, si bien qu'il produit un signal de sortie de conversion de fréquence, le ou lesdits moyens mélangeurs étant constitués d'un premier mélangeur et d'un deuxième mélangeur connectés en parallèle, et un premier circuit hybride et un deuxième circuit hybride, caractérisée par le fait que ledit premier circuit hybride a pour fonction de produire deux signaux de sortie présentant entre eux un déphasage d'une valeur prédéterminée $\phi_1$, dérivés d'un signal de sortie d'oscillation venant dudit oscillateur local, ledit deuxième circuit hybride a pour fonction de produire un déphasage d'une valeur prédéterminée $(\pi - \phi_1)$ entre les signaux de sortie des premier et deuxième mélangeurs et combine ces signaux de sortie de façon que ledit signal de sortie de conversion de fréquence soit produit à partir de ceux-ci; et par le fait que ledit signal de fréquence intermédiaire du premier mélangeur est déphasé de π radians par rapport au signal de fréquence intermédiaire du deuxième mélangeur, ladite valeur $\phi_1$ étant préréglée à $\phi_1 = +\pi/2$ comme valeur optimale.

2. Unité de conversion de fréquence selon la revendication 1, dans laquelle chacun desdits premier et deuxième mélangeurs est fabriqué sous forme d'un mélangeur à diodes, deux diodes du premier mélangeur sont disposées de manière à avoir des polarités inverses par rapport aux deux diodes du

**0 091 378**

deuxième mélangeur et, par conséquent, le signal de fréquence intermédiaire du premier mélangeur est nécessairement déphasé de π radians par rapport à celui du deuxième mélangeur.

3. Unité de conversion de fréquence selon la revendication 1, dans laquelle chacun desdits premier et deuxième circuits hybrides est fabriqué sous forme d'un circuit hybride à 3 dB.

4. Unité de conversion de fréquence selon la revendication 1, dans laquelle ladite valeur $\phi_1$ est choisie dans l'intervalle $+\pi \geqq \phi_1 \geqq 0$.

5. Unité de conversion de fréquence selon la revendication 2, dans laquelle lesdits signaux de fréquence intermédiaire desdits premier et deuxième mélangeurs sont délivrés en commun au moyen d'un circuit de dérivation en T à partir d'une source de signal de fréquence intermédiaire unique.

9

## Fig. 1

## Fig. 2

*Fig. 3*

*Fig. 4*

# Fig. 5

*Fig. 6*

Fig. 7